# EUROPEAN PATENT APPLICATION

(11) **EP 4 641 224 A1**
(43) Date of publication of application: **29.10.2025**
(21) Application number: 25173053.7
(22) Date of filing: 28.04.2025
(51) Int. Cl.: G01R 31/14

(54) **IMPULSE CURRENT GENERATOR WITH REAL-TIME CONTROLLABLE OUTPUT**

(30) Priority: 26.04.2024 GR 20240100302
(71) Applicant: Aristotle University Of Thessaloniki-Eidikos Logariasmos Kondilion Erevnas E.L.K.E., 54636 Thessaloniki (GR)
(72) Inventor: TSOVILIS, Thomas, 55337 Thessaloniki (GR); GEKTIDIS, Konstantinos, 57001 Triadi (Thermi Thessaloniki) (GR); ZARKA, Ilia, 57001 Nea Raidestos (Thessaloniki) (GR)
(74) Representative: Petsis, Christos

(57) **Abstract**

The invention refers to a controllable impulse current generator for testing surge protective devises under standard (8/20 µs, 10/350 µs), non-standard, and field-recorded impulse currents. It comprises a control circuit, a current sensing circuit, a variable-impedance device, a device under test and an energy source. It also refers to a related method notably wherein the control circuit monitors the impulse current and drives the variable-impedance device to ensure that the applied current conforms to a targeted output. This invention proves beneficial for use and applications in surge protection, insulation coordination, and hardware-in-the-loop simulations.

## Description

### FIELD OF THE INVENTION

The present invention relates to device testing and, more particularly, to devices for testing surge protective devices under impulse currents for a wide frequency and energy spectrum and methodologies therefor.

### BACKGROUND OF THE INVENTION

In the past decade, notable transformations within the electrical energy industry have encompassed the emergence of smart grids, encompassed incorporation of distributed generation, and acceleration of the shift from conventional to advanced transmission and distribution systems. The escalating stress entailed the need of integrating sensitive electrical, electronic, and telecommunication apparatuses sensitive to high-frequency overvoltage failures. Consequently, safeguarding this equipment from surges is essential to ensure reliable, sustainable, cost-effective, and secure operation of electrical installations.

Sensitive electronic equipment is typically safeguarded against transient overvoltages and surge through the use of Surge Protective Devices designated as SPDs. The effectiveness of said Surge Protective Devices in mitigating fast-front transients and safeguarding sensitive and high-value electronic equipment, is rigorously tested by the manufacturers using one or more testing standards. For instance, generators capable of producing high currents may be utilized to generate current waveforms in a laboratory environment.

High-current generators designed to produce current waveforms utilize passive elements such as capacitors, inductors, and resistors. These generators employ two-state switches, which are either in the on or off position, to discharge a capacitor bank onto the Device Under Test referred to as DUT. The characteristics of the impulse current waveform and the peak current are influenced by the electrical properties of the generator components, the charging voltage of the capacitor bank, and the impedance of the DUT.

Impulse current generators used in the surge protection industry traditionally rely on passive circuit components-such as capacitors, inductors, and resistors-and two-state switching mechanisms to produce impulse currents, with performance dependent on component characteristics and the impedance of the device under test (DUT).

### PRIOR ART

CN207181474U discloses a said high-current pulse generator with adjustable function designed to generate stable and powerful pulses for testing inductive power devices. This device uses multiple transformers, water resistances and pulse generators to ensure accurate measurements and meet test requirements. Furthermore, the transformer connection includes primary ends in parallel and secondaries in series. A switch controls the operation. The generator includes a control unit, display, and alarm for adjustment and safety. The device uses high-power water heaters made of copper in water, for efficient current management. It is compatible with normal city supply, making it useful in different environments.

CN113125910 A discloses a lightning surge testing device comprising components such as a power supply unit, switches and a unit for generating lightning waves. These are connected in series, with the central controller coordinating them, and there is also a feedback unit for collecting results. The lightning wave generating unit comprises at least one energy storage element and switches which control the charging and discharging of these elements.

None of these documents provides the use of a variable impedance device to control the impulse current flowing through the specimen, which is thus not disclosed in the cited prior art.

### AIM OF THE INVENTION

The aim of the invention is to remedy this lack, by enabling the use of a variable impedance device to control the impulse current flowing through the specimen.

It can thus be applied to test surge protection devices referred to as SPDs under surge currents for a wide range of power frequencies.

### SUMMARY OF THE INVENTION

Thanks to the invention, there is achieved a device for testing surge protective devices under impulse currents for a wide frequency and energy spectrum, with Impulse current generator with real-time controllable output device testing as set out below.

It is proposed a device according to the present invention that remarkably comprises
an energy storage system configured to supply output current for the device under test;
a variable-impedance device to control the impulse current flowing through the device under test;
a control circuit driving the variable-impedance device; and
a current sensing device providing feedback to the said control circuit.

A device according to the present invention thus remarkably includes a controllable output impulse current generator that is configured to provide a desired impulse current waveform.

The generator thus includes at least one variable-impedance device to control the current through the DUT. The generator includes a current sensing circuit to measure the current through the DUT. A control circuit uses the current sensing circuit to drive the said at least one variable-impedance devices to achieve the targeted output current. The generator further includes an energy source or energy storage system.

It is thus achieved with this invention at the heart of the current development, to replace conventional two-state switching with a dynamically controlled variable impedance device. Integrated with a current-sensing unit and a control circuit, this system enables real-time dynamic waveform synthesis, adapting to the DUT's abstract. As a result, it can generate impulse current waveforms that go beyond the predefined double-exponential shapes imposed by existing technologies.

According to a further embodiment of the present invention, a Device Under Test DUT is provided for the Testing device wherein said energy storage system resp. energy source supplies a signal s constituting the output current to said device under test DUT, wherein said variable-impedance device is connected to said device under test controlling the impulse current s flowing through the latter;
wherein said control circuit is connected to said variable-impedance device for driving same and wherein said current sensing device is connected to said control circuit for providing feedback thereto.

According to a particular embodiment of the device of the present invention, said energy source, the variable-impedance device, the control circuit, and the current sensing device are functionally interconnected, wherein
- the energy source is discharged to the device under test DUT through said variable-impedance device providing a high-current impulse,
- the actual impedance of the variable-impedance device) is controlled through a control circuit esp. at each time step to regulate the amplitude and shape resp. waveform of the high-current impulse,
- the control circuit dynamically adjusts the operation of the variable-impedance device in real time based on feedback from the current sensing continuously monitors the current delivered to the device under test, enabling precise shaping of the current waveform.

According to a more particular embodiment of the device of the invention, said variable-impedance device comprises ≥1 semiconductor-based component, esp. bipolar junction transistors.

According to an alternative embodiment of the device of the invention, said semiconductor-based components consist of field-effect transistors and/or insulated-gate bipolar transistors.

According to another particular embodiment of the device of the invention, the control circuit comprises a main control unit and a circuit generating signals for the variable-impedance device.

According to a further particular embodiment of the device of the invention, said device comprises an operational amplifier configured to provide the driving signal for the variable-impedance device.

According to a further particular embodiment of the device of the invention, said device comprises a filter, esp. configured to eliminate undesired oscillations.

According to an additional embodiment of the device of the invention, it comprises an impulse current generator that is configured to provide an impulse current that includes a targeted impulse current waveform to the device under test as test load during a test duration.

In particular, said specified waveform is a field-measured waveform.

Said specified waveform may be also a user-generated waveform, resp. a standard waveform provided by the international standards.

According to an advantageous embodiment of the device of the invention, the variable-impedance device is configurated in shunt series as protective device against overvoltages.

According to a specific embodiment of the device of the invention, the maximum output current is greater than about 1000 A and/or the minimum output rise time is lower than about 20 nanoseconds. Indeed, in some embodiments, the maximum output current is ≥1000 amperes.

According to an expanded embodiment of the device of the invention, there is provided an apparatus comprising an array of devices as set out above, wherein multiple variable-impedance devices and/or current sensing devices and/or control circuits are arranged in a parallel and/or in a series configuration, esp. according to a multidimensional raster of devices. it may thus incorporate multiple variable-impedance devices configured in parallel and/or in series.

The present invention also relates to a method for operating a device notably as set out above, wherein the controller communicates with a processing device, esp. an external processing device, and/or exchange, i.e. receives/sends trigger signals with other devices, esp. wherein said control circuit communicates with software running on said processing device, esp. through a processing algorithm. Indeed, in some embodiments, the controller may communicate with an external processing device and/or receive/send trigger signals with other devices.

According to a particular embodiment of the method of the invention, the targeted impulse current waveform is transferred to the main control unit, esp. by means of a particular software.

According to a more particular embodiment of the method of the invention, said specified waveform is computed in a simulation process, esp. by means of a simulation software.

According to an even more particular embodiment of the method of the invention, real time current values are transferred to the main control unit, esp. by means of said software.

According to a still more particular embodiment of the method of the invention, said microcontroller receives the trigger signal from an external source.

According to an outstanding embodiment of the method of the invention, a current is generated with a rise time of 20 nanoseconds or less.

According to a promising side-embodiment of the method of the invention, it comprises the operations associated with the method, and/or said apparatus resp. device including the steps successively consisting of
- enabling the energy source during a test duration,
- obtaining a predefined current waveform,
- sending target current values to the control signal generator, resp.
- generating driving signals for the variable-impedance devices.

The present invention also relates to some specific uses of a device as set out above, notably wherein a variable impedance device is used for controlling the impulse current flowing through the specimen or DUT.

In addition, there is also proposed according to the present invention the use of the device wherein said device under test DUT may be a spark gap and/or a gas discharge tube and/or a metal oxide varistor and/or a transient voltage suppressor diode and/or a battery and/or a supercapacitor and/or a diode.

Furthermore, it proposes the use of said device in a so-called hardware-in-the-loop application.

At last, there is also proposed according to the present invention a system for operating a device as defined above and/or with a method as set out above, wherein there is incorporated a controllable impulse current generator for testing surge protective devices under standard -esp. 8/20 µs, 10/350 µs-, non-standard, and field-recorded impulse currents, wherein the control circuit monitors the impulse current and drives the variable-impedance device to ensure that the applied current conforms to a targeted output.

In summary, according to a more specific embodiment of the device of the present invention, there is incorporated a controllable impulse current generator for testing surge protective devices under standard -i.e. 8/20 µs, 10/350 µs-, non-standard, and field-recorded impulse currents. It comprises a control circuit, a current sensing circuit, a variable-impedance device, a device under test and an energy source. The control circuit monitors the impulse current and drives the variable-impedance device to ensure that the applied current conforms to a targeted output.

In view thereof, this invention proves beneficial for applications in surge protection, insulation coordination, and hardware-in-the-loop simulations.

Moreover, some embodiments may use a main control unit as part of the control circuit. A current sensing device may be used to get a feedback signal for the circuit.

A control signal generator may be used to drive the variable-impedance device appropriately.

In some embodiments, the controller receives a targeted current waveform from an external device. In some other embodiments, the current waveform can be a comma separated values file.

In some further embodiments, said waveform may be a standard waveform, and/or simulation generated waveform, and/or field-measured waveform and/or user generated waveform.

In other embodiments, the external device may directly send real-time target current values to the generator.

Thanks to the invention, there is thus achieved a novel controllable impulse current generator, notably tailored for incorporation into a power hardware-in-the-loop (HIL) testing framework. The generator is capable of producing impulse current waveforms both computed via simulation software and recorded from real-world field data. This capability enables enhanced testing of surge protective devices and sensitive electrical and electronic equipment, supporting the advancement and deployment of next-generation surge protection technologies. Detailed technical specifications for both power and control circuits are outlined, with a comparison between targeted and recorded waveforms found in good agreement. An application of simulation-based impulse currents on various surge protective devices is provided, determining the use of this tool for insulation coordination and surge protection applications to address challenges of modern power systems.

This invention provides a novel controllable impulse current generator designed for integration into an advanced setup of some testing system, esp. Power HIL, wherein the generator can produce current waveforms computed in simulations software, standard, non-standard and field-recorded impulse current waveforms, for testing surge protective devices, and sensitive electrical and electronic equipment. The technical specifications of the generator, for both power and control circuits, are provided; tests to demonstrate comparison between targeted and output current waveforms were made. An application of impulse currents on different surge protective and electronic components is made, which can be an effective tool for applications related to insulation coordination and surge protection.

Conventional generators, which produce only predefined double-exponential or rectangular waveforms, are unsuitable in this testing context and are limited to standalone use. This work introduces a controllable impulse current generator that replaces the traditional two-stage switch with a variable-impedance device based on semiconductors. This controlled semiconductor device ensures that the output current waveform matches the targeted output. Consequently, this generator is able to produce impulse current waveforms beyond the standard double-exponential and rectangular shapes. Hence, waveforms with a maximum current derivative near the peak value can be produced, and the modelling process under fast-front transients can surpass the constraints imposed by the standard waveforms utilized so far, whereas models based on standard waveforms perform poorly under non-standard conditions. The range of impulse current waveforms that can be tested in laboratory environment is significantly broadening.

The accompanying drawings are provided to enhance the understanding of the present invention and are incorporated into and form a part of this specification. These drawings depict various exemplary embodiments of the present invention and, in conjunction with the description, elucidate the principles underlying the present invention. The drawings may present certain regions or features with exaggerated dimensions to enhance clarity. Identical reference numerals throughout the drawings indicate identical elements.

### BRIEF DESCRIPTION OF THE DRAWINGS

FIG. 1 is a diagram illustrating a conventional exponential impulse current generator that can operate with or without the crowbar mechanism.
FIG. 2 is a graph illustrating a double exponential impulse current.
FIG. 3 is a diagram illustrating a rectangular current generator.
FIG. 4 is a block diagram illustrating an embodiment of a conventional impulse current generator.
FIG. 5 is a block diagram illustrating the power circuit according to an embodiment of the present invention.
FIG. 6 illustrates an embodiment of an energy source according to the invention.
FIG. 7 illustrates an embodiment of the current regulation circuit with multiple variable-impedance devices configurated in parallel. according to the invention.
FIG. 8 illustrates an embodiment of the current regulation circuit with parallel and/or series configurated current sensing and/or variable-impedance devices. according to the invention.
FIG. 9 illustrates a current regulating circuit according to an embodiment of the present invention.
FIG. 10 is a diagram of the control circuit according to an embodiment of the present invention.
FIG. 11 illustrates a control signal generator circuit according to an embodiment of the present invention.
FIG. 12 illustrates a module of a current impulse generator according to an embodiment of the current invention.
FIG. 13 illustrates a modular current impulse generator according to an embodiment of the current invention.
FIG. 14 depicts a block diagram illustrating operations corresponding to systems, methods, and apparatus for generating controllable impulse currents according to certain embodiments of the present invention.
FIG. 15 illustrates a current output resembling field-recorded downward double peak flash.
FIG. 16 illustrates another current output resembling field-recorded upward flash.

### DETAILED DESCRIPTION

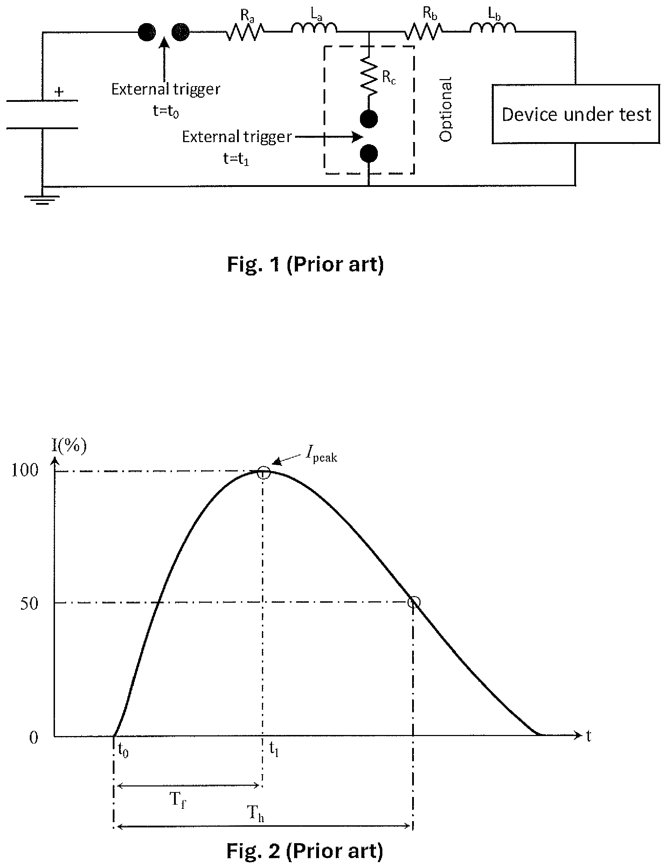

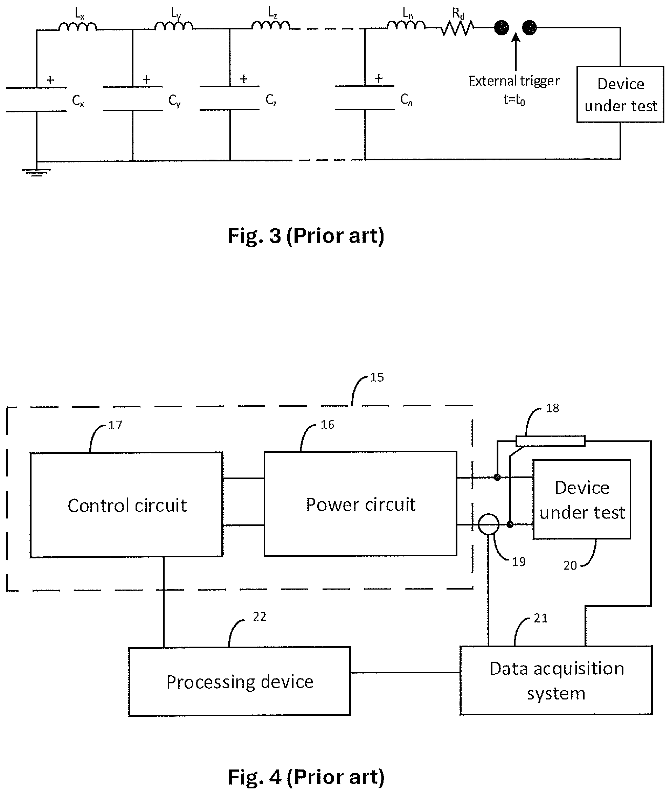

FIG. 1 and 3 illustrate conventional impulse current generators, wherein FIG. 1, excluding the merely optional dashed box 11, displays schematically an impulse current generator of traditional type, which can generate exponential impulse currents as depicted in Fig. 2. The international testing standard IEC 61643 specifies the 10/350 microsecond and 8/20 microsecond impulse current waveforms, where the peak current (100%) is reached (T_{f}) approximately 10 microseconds after initiation, respectively, with the current decreasing to 50% (Tₕ) of the maximum at approximately 350 microseconds and 20 microseconds, respectively.

Another category of impulse current generators, illustrated in Fig. 1 including said optional dashed box 11, employs a crowbar-type mechanism. This configuration utilizes two two-stage switches: the first to initiate the impulse current (t₀) and the second to truncate the waveform (t₁), effectively controlling the duration of charge stresses applied to the device under test 20 referred to as DUT.

The circuit of FIG. 1 generates exponential current waveforms, by utilizing capacitors, switches and an R-L circuit. The crowbar circuit in the dashed line may be used to truncate the waveform. An example of an exponential waveform is shown in FIG. 2.

Another variety of current generators is depicted in Fig. 3, which has the capability to generate rectangular current waveforms. The circuit in FIG. 3 uses multiple L-C circuits in parallel to get a rectangular current output on the DUT.

FIG. 4 illustrates a conventional impulse current generator. A Device Under Test 20 referred to as DUT is placed on the output of the impulse current generator. A data acquisition system 21 receives signals s1, s2 from a voltage probe 18 and a current transformer 19. Some embodiments may require the data acquisition device to be, for example, an oscilloscope. Some embodiments may require the communication of the data acquisition system 21 with a processing device 22 for further data analysis. Some other embodiments may require the processing device 22 to communicate with the control circuit 17 of the impulse current generator. The processing device 22 may be any kind of device capable of the required communications and/or processing capabilities for each embodiment, for example a mobile and/or a stationary computer.

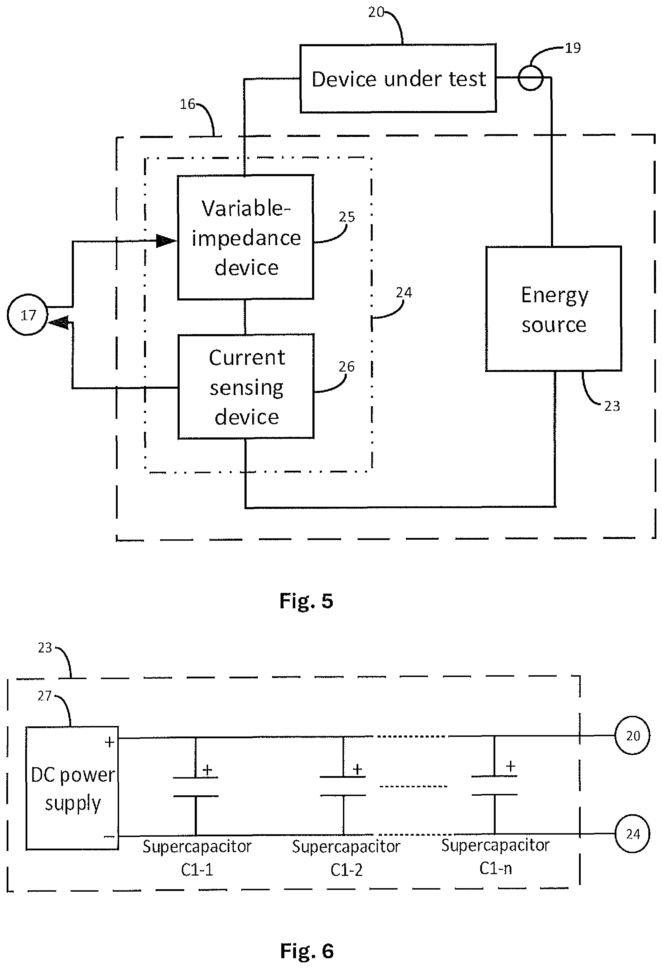

FIG. 5 is a block diagram of the power circuit 16, according to the invention. Semiconductor-based components are used as variable-impedance devices 25, preferably bipolar junction transistors. Another example of variable-impedance devices includes filed effect transistors and/or insulating gate bipolar junction transistors. This embodiment may require a current sensing device 26,_e.g. consisting of a shunt resistor and/or a current transformer and/or a Hall sensor and/or a Rogowski coil. Some embodiments use energy source 23 in series with the DUT 20.

FIG. 6 illustrates an embodiment of an energy source 23 consisting of a plurality of supercapacitors C1-1, C1-2,.., C1-n, arranged in parallel, with an equivalent series resistance in the range of 1 mΩ to 100 mΩ and/or a DC power supply, being understood that the use of a power source 23 is non-limiting. Alternatively, the supercapacitors C1-1, C1-2, C1-n may also be configured in series and/or in parallel. Other examples of a power source 23 include a battery bank and/or capacitors and/or power supplies.

An example of Capacitor bank C₁,.. is based on an electrolytic capacitor bank used to store energy required for the impulse current. The bank is connected in series with the device under test 20. To achieve high capacitance, fast response and low Equivalent Series Resistance ESR, e.g. ten 150 µF capacitors are configurated in parallel. The capacitor bank is charged by a DC power supply at 200 V in series with a 1 kΩ resistor to reduce charge current R₂. Although the capacitor bank can handle up to 400 V, the charging voltage is limited to 200 V to comply with the transistor maximum rating.

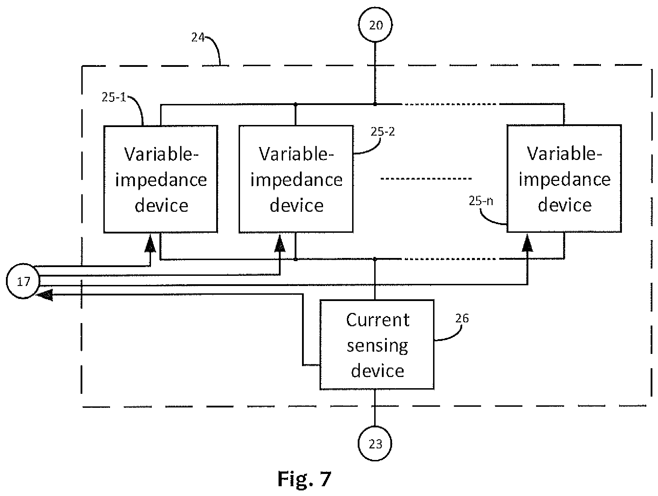

FIG. 7 illustrates an embodiment of a current regulating circuit 24 incorporating multiple variable-impedance devices 25. In the shown embodiment, there is a single current sensing circuit 26 arranged in series with an array of variable-impedance devices 25-1, 25-2, ..., 25-n. esp. unidimensional.

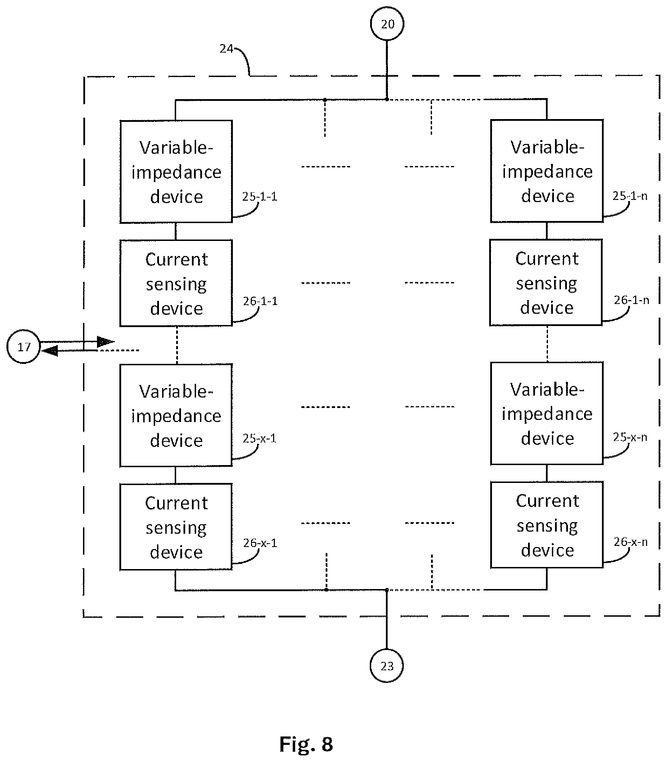

FIG. 8 is an illustration of a further embodiment of a current regulating circuit 24 including an array arrangement -esp. bidimensional- as a field display, of multiple variable-impedance devices 25-1-1 to 25-x-n and/or multiple current sensing devices in series and/or in parallel configuration. The current sensing devices 26-1-1 to 26-x-n and variable-impedance devices 25-1-1 to 25-x-n, may be any variation and/or combination of variable-impedance devices 25 and/or current sensing devices 26 mentioned herein. A multiple variable-impedance device 25 comprises multiple components configured in series and/or parallel configuration. A current sensing device 26 as shown in FIG. 8, may be used at any part of the power circuit 16 and/or comprise an input from an external device. Multiple control and/or sensing signals are thus affordable.

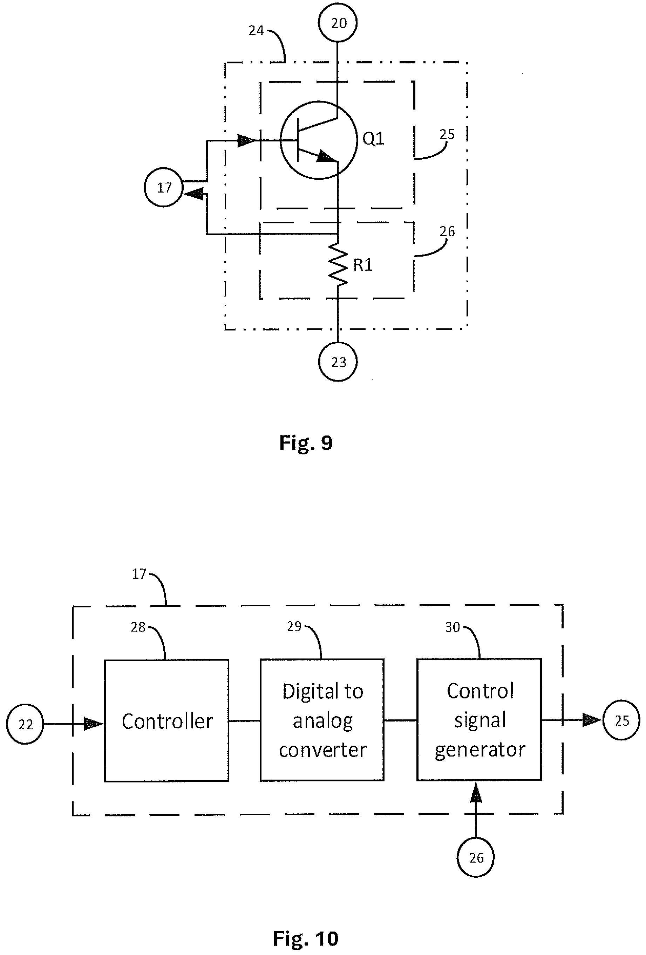

FIG. 9 is an embodiment of the current regulating circuit 24. In this example, an NPN bipolar junction transistor Q1 consists of a variable-impedance device 25. The current handling capabilities of such a transistor *may be* in the range of 1 mA to 20 kA. The control signal s_{c} from the control signal generator 30 in this embodiment is a current flowing through the base of the transistor Q1. Other embodiments may use other means of control, some examples of which are voltage levels *and*/*or* digital signals. The feedback 26 from the current sensing device 26, may be the voltage drop across a shunt resistor, as shown in FIG. 8. The value of such a resistor is in the range of e.g. 100 µΩ to 10 Ω. Other embodiments *may* use other methods for converting the current through the power circuit 16 to an appropriate signal for the control circuit 17.

In the following example, NPN BJT transistors Q1 serve as controllable variable-impedance switches, by regulating the current at the source (*I_{base}*). These transistors function in the active mode as current amplifiers and they are arranged in parallel, e.g. comprising 60 transistors in total, capable of withstanding a maximum voltage of 200 V. Each transistor operates at a maximum impulse current of 5 A, ensuring safe operation for ~400 µs maximum duration, enabling a total maximum of 300 A. In addition to BJTs, various controllable semiconductors such as MOSFETs, including SiC and GaN variants, can be utilized to achieve the desired current control. However, the generator performance will be inherently limited by the properties of these semiconductors. Typically, MOSFETs exhibit significantly higher input capacitance compared to BJTs, which poses challenges in achieving the necessary high operational speed and small time steps, particularly within nanosecond to microsecond range. Experimental investigations with silicon MOSFETs revealed that BJTs offer superior performance in enhancing the generator rise time.

A Shunt resistor R₁ is incorporates wherein a low-inductance surface-mount device resistor of e.g. 0.1 Ω is placed in series with every six transistors to monitor generated impulse current. The equivalent series resistance of ten parallel resistors is 0.01 Ω because all the transistors are connected in parallel. The voltage drop across this resistor is employed as feedback within the control circuit.

The power circuit of the controllable impulse current generator is similar to the direct type and crowbar type generators; it differs in the utilization of controllable semiconductor switches in place of two-stage switches (mechanical, spark gaps). The impulse current (*I_{load}*) flows exclusively in the direction illustrated in Fig. 9, allowing for the controlled discharge of a charged capacitor bank into the device under test 20. Components of the generator power circuit are depicted in the dashed box.

FIG. 10 is a block diagram of the control circuit 17. Some embodiments of the invention may use a DC power supply for its components, directly coupled or galvanically isolated. A controller 28 is used allowing to communicate with external devices 22 *and*/*or* receive external signals and output the appropriate signals for the rest of the circuit. A Digital to Analog Converter DAC 29 may be used to generate the appropriate control signals. Examples of DACs include resistor arrays and/or discrete DAC integrated circuits. Some embodiments of the invention may use control signal generator circuit 30, to drive the variable-impedance device 25. The control signal generator may use any voltage and/or current value as input. The control signal generator may be coupled to any part of the generator. The control signal generator may use galvanic isolation for signal and/or power input *and*/*or* output. Non limiting examples of galvanic isolation for the control signal generators 30 are isolated DC-DC power supplies, digital and/or analog optocouplers.

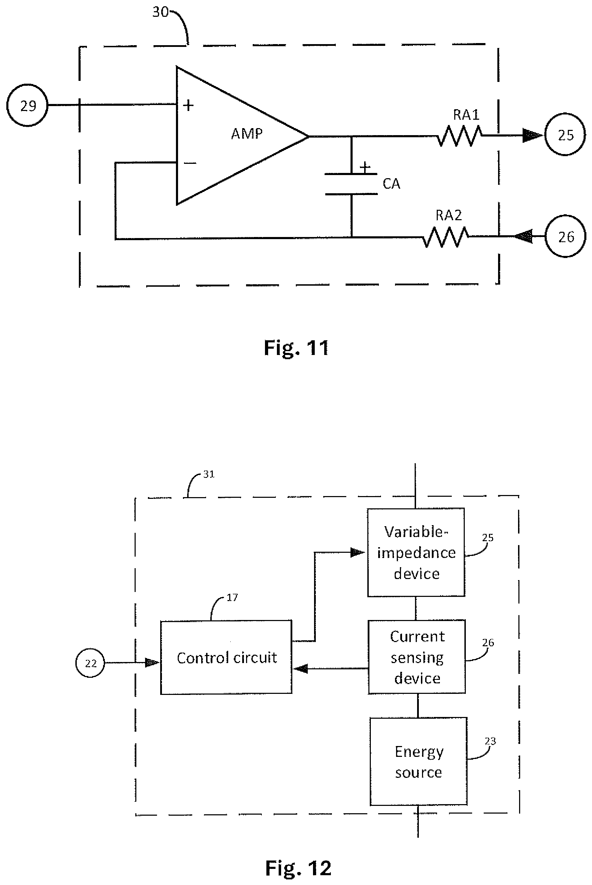

FIG. 11 is an embodiment of the control signal generator 30, which is connected with the current regulating circuit 24 shown in FIG. 9. An operational amplifier AMP 31 compares the feedback signal to the signal from the controller 29. Said amplifier 31 has a maximum output current in the range of e.g. 1 mA to 10 A. A resistor RA1 is incorporated between the output of the operational amplifier 31 and the variable-impedance device 25 to limit the current flow. RA1 may have a value in the range of 1 mΩ to 100 kΩ. In the example shown in FIG. 10, the operational amplifier 31 receives an analog voltage originating from the controller and a feedback voltage from the shunt resistor 27 and drives the variable-impedance device 25 such that the current through it equals the target output current.

Other embodiments of the invention may use different methods of comparing signals *and*/*or* generating the control signal for the variable-impedance device 25. An example thereof is converting the analog signals to digital, comparing the values through software and generating the control signal.

A filter 32 consisting of a capacitor CA and a resistor RA2 is advantageously incorporated to eliminate oscillations. CAs value may be in the range of 1 pF to 100 µF and RA2 may be in the range of 10 mΩ to 1 MΩ. Other embodiments may not need such filters due to different component selection and/or use different circuits to eliminate the oscillations.

FIG. 12 shows an embodiment of a power module 31, according to some embodiments of the current invention. In some embodiments, a power module may consist of a variable impedance device 25 and/or a current sensing device 26 and/or an energy source 23 and/or a control circuit 17.

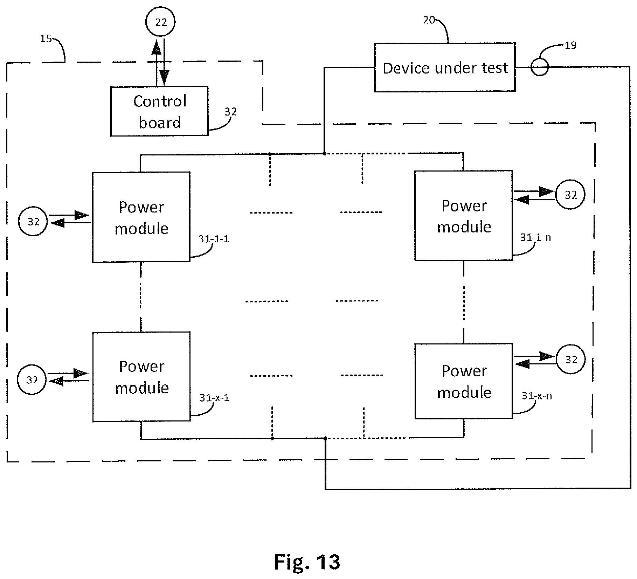

FIG. 13 shows an embodiment of a modular generator. Some embodiments may use multiple power modules 35 in series and/or in parallel. In some embodiments, the power modules are connected to a control board 32, which may communicate with external devices 22.

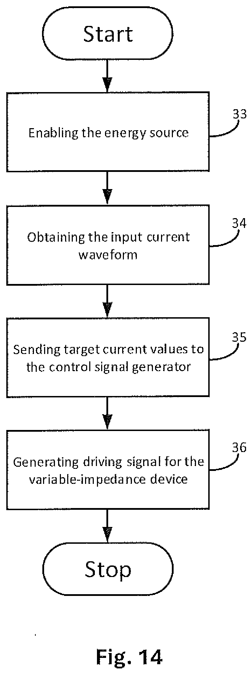

FIG. 14 depicts a block diagram that illustrates operations associated with systems, methods, and apparatuses according to *certain embodiments* of the present invention. Some embodiments may require enabling the energy source during a test duration 33, whereas some embodiments may require obtaining a predefined current waveform 34. Some embodiments may require sending target current values to the control signal generator 35, whereas some embodiments may require generating driving signals for the variable-impedance devices 36.

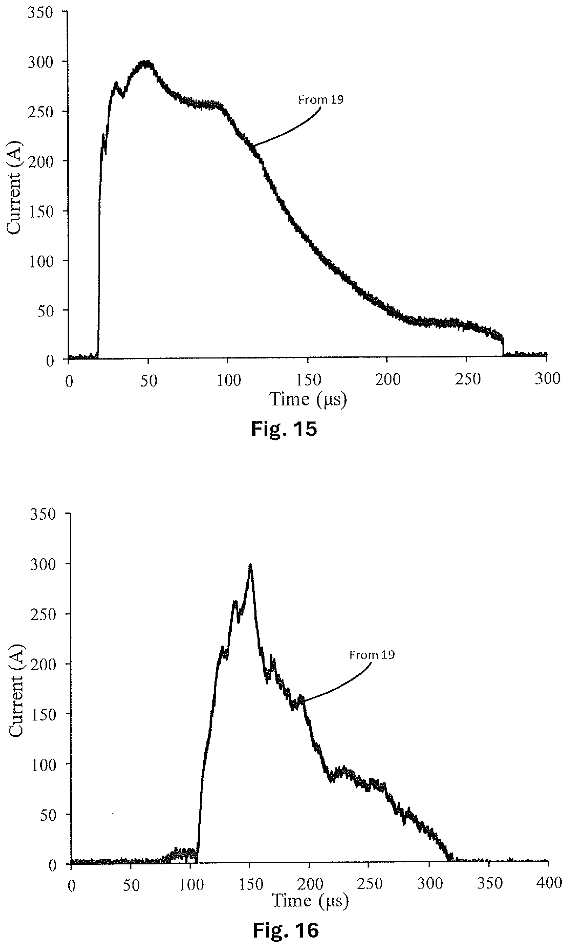

FIG. 15 and 16 highlight the capabilities of the current invention. The waveforms of the figures resemble field-measured currents which are very hard to accomplish with traditional impulse current generators, yet very easy with the present invention.

Some embodiments of the present invention may be applicable to testing surge protection systems; however, such embodiments are non-limiting. Some examples of uses of this invention for other purposes include devices for a) active protection against overvoltages and b) determination of the transient impedance of electrical systems and c) electromagnetic pulse generation.

As a proof of concept, a prototype generator was utilized to demonstrate the accuracy of the measured output waveforms compared to the targeted ones.

The controllable impulse current generator can produce a diverse range of current waveforms, making it versatile for various application. These tests could not be carried out with traditional impulse current generators, programmable high voltage sources, or combination wave generators, as none of these devices can produce controllable current waveforms. Conventional current generators produce only predefined waveforms, while high voltage generators, whether programmable or not, have currents determined by the impedance of the device under test. The presented generator offers an advantage over known generators discussed in the literature by employing a controllable variable-impedance device for real-time control of the generated current. That enables implementation in said PHIL applications.

The desired waveforms must adhere to certain restrictions, ensuring the safe and reliable operation of the generator. It could be deduced that a novel controllable impulse current generator can be used within power hardware-in-the-loop testing systems. The generator offers advanced testing capabilities for development and implementation of innovative technologies within the power industry. The design of the generator has been analyzed, and a validation procedure has been demonstrated. An application involving testing limiting type surge protective components and critical electrical equipment (diode, capacitor, PTC, battery, and supercapacitors) under standard, non-standard, simulation-based, and field-recorded current waveforms has been made. Experimental findings have notably revealed that:
- this generator allows for impulse current generation that cannot be produced by conventional impulse current generators using passive components,
- output waveforms closely align with the targeted across various types of loads.

### Keywords

Active current control, Controllable Power Supplies, Fast-front transients, Hardware in the Loop, Impulse Current Generator, Nuclear Electromagnetic Pulses, PHIL, Pulse generators, Surge protection, Variable-Impedance Device.

It is to be understood that the term "coupled" or "connected," as used herein, may denote either direct or indirect connections between elements, whereas "directly coupled" or "directly connected" indicates that no intermediate elements are involved.

Furthermore, spatial relationship terms such as "below," "under," "lower," "above," "over," and "upper" are used for descriptive purposes only, to explain the position of one element or feature relative to another as depicted in the figures. It is to be appreciated that these terms cover different device orientations during use or operation beyond those shown in the figures. For instance, what is described as "below" or "under" could be "above" when the device orientation is inverted. Such terms should be interpreted relative to the device's orientation.

## Claims

1. A device comprising:
an energy storage system (23) configured to supply output current for a device under test (20);
a variable-impedance device (25) to control the impulse current (I_{load}) flowing through the device under test (20);
a control circuit (17) driving the variable-impedance device (25); and
a current sensing device (26) providing feedback to the control circuit (17).

2. Testing device according to claim 1, **characterized in that** said energy storage system comprising an energy source (23) supplies a signal constituting an output current to said device under test (20),
wherein the controlled variable-impedance device (25) is connected to said device under test (20) in series, the impulse current (s) flowing through the latter (20);
wherein said control circuit (17) is connected to said variable-impedance device (25) for driving same (25) and
wherein said current sensing device (26) is connected to said control circuit (17) for providing said feedback thereto (17).

3. The device according to one of the claims 1 to 2, **characterized in that** said variable-impedance device (25) comprises ≥1 semiconductor-based components, in particular bipolar junction transistors (BJT).

4. The device according to one of the claims 1 to 3, **characterized in that** said variable-impedance device (25) comprises ≥1 semiconductor-based components consisting of field-effect transistors *and*/*or* insulated-gate bipolar transistors.

5. The device according to one of the *preceding* claims 1 to 4, wherein said control circuit (17) comprises a controller (28), a digital-to-analog converter (29) and a control signal generator (30) for generating signals to drive the variable-impedance device (25).

6. Testing device according to one of the preceding claims 1 to 5, **characterized in that** said device comprises an operational amplifier (31) configured to provide the driving signal for the variable-impedance device (25), esp. to compare the feedback signal to the signal from the controller (29), particularly wherein said amplifier (31) has a maximum output current in the range of 1 mA to 10 A, more particularly wherein a resistor (RA1) is incorporated between the output of the operational amplifier (31) and the variable-impedance device (25).

7. Testing device according to one of the preceding claims 1 to 6, **characterized in that** said device comprises a filter (32), in particular comprising a capacitor (CA) and a resistor (RA2), esp. configured to eliminate oscillations.

8. Testing device according to one of the preceding claims 1 to 7, **characterized in that** it comprises an impulse current generator (15) that is configured to provide an impulse current that includes a targeted impulse current waveform to the device under test (20) as test load during a test duration,
in particular wherein said specified waveform is a field-measured waveform or a user-generated waveform.

9. Device according to one of the preceding claims 1 to 8, wherein variable-impedance device (25) is configurated in shunt series as protective device against overvoltages.

10. The device according to one of the preceding claims 1 to 9, wherein the maximum output current is greater than about 1000 A and/or wherein the minimum output rise time is lower than ≤ about 20 nanoseconds.

11. Apparatus comprising an array of devices according to one of the preceding claims 1 to 10, wherein multiple variable-impedance devices (25-1-1, ...25-x-1,...25-1-n,..25-x-n) and/or current sensing devices (26-1-1, ...26-x-1,...26-1-n,..26-x-n) and/or control circuits (17) are arranged in a parallel and/or in a series configuration.

12. Method esp. for operating a device according to any one of the preceding claims 1 to 11, **characterized in that** the energy source (23), the variable-impedance device (25), the control circuit (17), and the current sensing device (26) are mutually interconnected functionally, wherein
- the energy storage system (23) is discharged to the device under test (20) through said variable-impedance device (25) providing a high-current impulse,
- the actual impedance of the variable-impedance device (25) is controlled through a control circuit (17) to regulate amplitude and waveform of the high-current impulse,
- the control circuit (17) dynamically adjusts the operation of the variable-impedance device (25) in real time based on feedback from the current sensing device (26) continuously monitors the current delivered to the device under test (20), enabling precise shaping of the current waveform.

13. Method for testing surge protective devices under impulse currents, esp. according to claim 12, wherein the controller (17) communicates with a processing device (22), esp. external, and/or exchanges resp. receives/sends trigger signals with other devices,
particularly wherein said controller (17) communicates with software running on said processing device (22).

14. Method according to claim 12 or 13, wherein the targeted impulse current waveform is transferred to the main control unit (17), esp. by means of said software.

15. Method according to one of the claims 12 to 14, wherein said specified waveform is computed in a simulation process, esp. by means of a simulation software.

16. Method according to one of the claims 12 to 15, wherein real time current values are transferred to the main control unit (17), esp. by means of said software.

17. Method according to claims to one of the claims 12 to 16, **characterized in that** it comprises operations associated with the method, and/or said apparatus resp. device including the steps successively consisting of
- enabling the energy source during a test duration (31),
- obtaining a predefined current waveform (32),
- sending target current values to the control signal generator (33), resp.
- generating driving signals for the variable-impedance devices (34).

18. Use of a variable impedance device (25) as defined in any of the claims 1 to 11 for controlling the impulse current flowing through said device under test (20).

19. Use of the device according to one of the claims 1 to 11, wherein that said device under test (20) DUT consists of a spark gap and/or a gas discharge tube and/or a metal oxide varistor and/or a transient voltage suppressor diode and/or a battery and/or a supercapacitor and/or a diode.

20. Use of the device according to one of the claims 1 to 11, in a so-called hardware-in-the-loop.
